# EUROPÄISCHE PATENTSCHRIFT

(11) **EP 2 708 907 B1**
(45) Veröffentlichungstag und Bekanntmachung des Hinweises auf die Patenterteilung: **07.08.2019**
(21) Anmeldenummer: 13196147.6
(22) Anmeldetag: 24.08.2012
(51) Int. Cl.: G01R 27/20, G01R 31/327

(54) **Verfahren und Vorrichtung zur Messung von Widerständen von Schaltkontakten eines elektrischen Leistungsschalters**
Method and apparatus for measuring resistances of switch contacts in an electrical power circuit breaker
Procédé et dispositif de mesure de résistances de contacts de commutation d'un commutateur de puissance électrique

(43) Veröffentlichungstag der Anmeldung: 19.03.2014
(62) Teilanmeldung aus: 12006040.5
(73) Patentinhaber: Omicron electronics GmbH, 6833 Klaus (AT)
(72) Erfinder: Klapper, Ulrich, 6830 Rankweil (AT); De Villiers, Wernich, 6850 Dornbirn (AT); Kaufmann, Reinhard, 6721 Thüringerberg (AT)
(74) Vertreter: Banzer, Hans-Jörg

(56) Entgegenhaltungen:
- WO-A1-2004/095667
- WO-A1-2009/131530
- DE-A1- 3 715 014
- NILS WÄCKLÉN ET AL: "High voltage circuit breaker testing with dual grounding", ENERGIZE, Nr. May 2008, 1. Mai 2008 (2008-05-01), Seiten 52-55, XP055054228,
- ZORAN STANISIC: "Method for static and dynamic resistance measurements of HV circuit breaker", INNOVATIVE SMART GRID TECHNOLOGIES (ISGT EUROPE), 2011 2ND IEEE PES INTERNATIONAL CONFERENCE AND EXHIBITION ON, IEEE, 5. Dezember 2011 (2011-12-05), Seiten 1-5, XP032136558, DOI: 10.1109/ISGTEUROPE.2011.6162618 ISBN: 978-1-4577-1422-1

## Beschreibung

Die vorliegende Erfindung betrifft ein Verfahren und eine Vorrichtung zur Messung von Widerständen von in einer Reihenschaltung angeordneten Schaltkontakten eines elektrischen Leistungsschalters. Die vorliegende Erfindung betrifft insbesondere eine Messung von Übergangswiderständen der geschlossenen Schaltkontakte des elektrischen Leistungsschalters.

Leistungsschalter, welche auch als Hochspannungsschalter, Lastschalter oder Circuit Breaker bezeichnet werden, werden in der Energietechnik verwendet, um elektrische Verbindung unter Last herzustellen oder zu trennen. Die Nennspannungen der Leistungsschalter können im Bereich von wenigen Volt bis zu einigen hundert Kilovolt liegen. Die geschalteten Lastströme können bei einem Kurzschluss mehrere zehn Kiloampere betragen. Für einen zuverlässigen Betrieb des Leistungsschalters wird daher beispielsweise im Rahmen von Revisionen der Übergangswiderstand eines Schaltkontakts oder mehrerer in Reihe angeordneter Schaltkontakte des elektrischen Leistungsschalters überprüft.

Leistungsschalter für Mittelspannungsanlagen haben meist nur einen Schaltkontakt, welcher geöffnet oder geschlossen werden kann. Leistungsschalter in Hoch- und Höchstspannungsanlagen können mehrere Schaltkontakte, sogenannte Unterbrechereinheiten, in einer Reihenschaltung umfassen. Bei der Reihen- oder Serienschaltung mehrerer Unterbrechereinheiten werden im Allgemeinen noch Kondensatoren mit einer Größe im Bereich von einigen Pikofarad parallel zu den einzelnen Unterbrechereinheiten angeordnet, um die Spannung gleichmäßig über die einzelnen Unterbrechereinheiten zu verteilen. Mehrere Unterbrechereinheiten in einer Phase eines Leistungsschalters werden im Allgemeinen gleichzeitig geöffnet oder geschlossen.

Bei Leistungsschaltern ist die Widerstandsmessung am geschlossenen Schaltkontakt, welche auch als Mikroohmmessung bezeichnet wird, ein Standardverfahren zur Beurteilung einer Qualität oder eines Verschleißzustandes des Leistungsschalters.

Die Mikroohmmessung wird üblicherweise durchgeführt, indem beispielsweise ein hoher Gleichstrom von 100 Ampere über den geschlossenen Schaltkontakt eingeprägt wird. Der Strom wird dazu über Stromklemmen eingespeist, welche an beiden Seiten des Leistungsschalters an die Leiter, welche vom Leistungsschalter wegführen, angeklemmt werden. Mit weiteren Klemmen wird die Spannung ebenfalls an beiden Seiten des Leistungsschalters abgegriffen. Die Spannungsklemmen werden üblicherweise näher am Schaltkontakt des Leistungsschalters angebracht und somit eine sogenannte Vierdrahtmessung durchgeführt. Dadurch kann verhindert werden, dass der Spannungsabfall an den Stromklemmen mitgemessen wird, wodurch das Messergebnis verfälscht werden würde. Aus eingeprägtem Strom und gemessener Spannung kann der Widerstand des geschlossenen Schaltkontakts inklusive des Widerstandes der Zuleitungen von den Spannungsklemmen bis zum Schaltkontakt bestimmt werden. Alternativ können statt getrennter Strom- und Spannungsklemmen sogenannte Kelvinklemmen zum Einsatz kommen. Bei Kelvinklemmen sind zwei Backen einer jeweiligen Klemme voneinander elektrisch isoliert und über eine der zwei Backen wird der Strom eingespeist und über die andere der zwei Backen wird die Spannung abgegriffen. Der Vorteil dieser Kelvinklemmen ist, dass nur eine Klemme an jeder Seite des Leistungsschalters anzuklemmen ist.

Zur Mikroohmmessung können, wie zuvor beschrieben wurde, eine Stromquelle und ein Spannungsmesser verwendet werden, sodass Spannungsmessungen an den verschiedenen Schaltkontakten nacheinander durchgeführt werden können. Es können auch mehrere Spannungsmesser verwendet werden, wobei mit einer gemeinsamen Stromquelle über mehrere Kontakte der Strom eingeprägt wird und mit den mehreren Spannungsmessern mehrere Spannungswerte gleichzeitig ermittelt werden können.

Da in energietechnischen Anlagen, beispielsweise in einem Umspannwerk, an vielen Stellen gefährlich hohe Spannungen auftreten können, ist es notwendig den Leistungsschalter während dieser Mikroohmmessung zu erden. Beispielsweise kann der Leistungsschalter an beiden Seiten vom übrigen Energienetz getrennt werden und an einer Seite geerdet werden. Die Mikroohmmessung kann dann bei geschlossenem Schaltkontakt oder geschlossenen Schaltkontakten präzise durchgeführt werden. Häufig sind weitere Messungen an dem Leistungsschalter durchzuführen, bei denen der Schaltkontakt zumindest zeitweise geöffnet sein muss, beispielsweise eine Messung der Zeit, die der Schalter zum Öffnen benötigt. Bei derartigen Messungen ist eine beidseitige Erdung des Schalters empfehlenswert, um eine Gefährdung von Personen, welche die Messung durchführen, zu vermeiden. Für die Mikroohmmessung wird daher eine der beiden Erdungen für die Dauer der Messung entfernt werden, was jedoch sehr umständlich ist, oder die Mikroohmmessung wird bei beidseitiger Erdung durch die parallele Erdschleife fehlerhaft.

Um eine Mikroohmmessung an einem Leistungsschalter effizient durchführen zu können, kann der Leistungsschalter beidseitig geerdet werden und mit einer gleichstromfähigen Stromzange oder einem Shunt der Anteil des Stroms, welcher von der Stromquelle durch die Erdungsgarnituren fließt, ermittelt werden und zur Korrektur des gemessenen Widerstands herangezogen werden. Dieses Verfahren ist zwar sehr genau, hat jedoch den Nachteil, dass zusätzliche Messungen mittels der Stromzange oder dem Shunt erforderlich sind.

In diesem Zusammenhang wird in der Veröffentlichung NILS WÄCKLEN ET AL: "High voltage circuit breaker testing with dual grounding", ENERGIZE, Nr. May 2008, 1. Mai 2008 (2008-05-01), Seiten 52-55, XP055054228 eine Mikroohmmessung beschrieben. Es wird ein Strom durch ein Testobjekt, beispielsweise einen Leistungsschalter, erzeugt und der Spannungsabfall an dem Testobjekt gemessen. Es ist möglich, den Widerstandstest durchzuführen, während beide Seiten des Testobjekts geerdet sind. Der erzeugte Strom weist zwei Pfade auf und ist daher nicht gleich dem Strom durch das Testobjekt. Wenn der Strom durch Erde gemessen wird, entspricht der Strom durch das Testobjekt dem erzeugten Strom minus dem Erdschleifenstrom. Der Spannungsabfall wird wie üblich gemessen. Auf diese Art und Weise kann der Widerstand gemessen werden, wobei beide Seiten des Testobjekts geerdet sind. Ein Messen des Erdungsschleifenstroms mit einer Stromzange ergibt eine ausreichende Genauigkeit.

Aufgabe der vorliegenden Erfindung ist es daher, eine effiziente Widerstandsmessung oder Mikroohmmessung für einen oder mehrere Schaltkontakte eines elektrischen Leistungsschalters zu ermöglichen, wobei eine Gefährdung von Personal, welches die Widerstandsmessung durchführt, weitestgehend vermieden werden sollte.

Diese Aufgabe wird gemäß der vorliegenden Erfindung durch ein Verfahren zur Messung von Widerständen von in einer Reihenschaltung angeordneten Schaltkontakten eines elektrischen Leistungsschalters nach Anspruch 1 und eine Vorrichtung zur Messung von Widerständen von in einer Reihenschaltung angeordneten Schaltkontakten eines elektrischen Leistungsschalters nach Anspruch 10 gelöst. Die abhängigen Ansprüche definieren bevorzugte und vorteilhafte Ausführungsformen der Erfindung.

Gemäß der vorliegenden Erfindung wird ein Verfahren zur Messung von Widerständen von Schaltkontakten eines elektrischen Leistungsschalters bereitgestellt. Die Schaltkontakte des elektrischen Leistungsschalters sind in einer Reihenschaltung angeordnet. Bei dem Verfahren wird ein erster Messstrom in einer ersten Richtung durch einen ersten Schaltkontakt der in der Reihenschaltung angeordneten Schaltkontakte eingespeist oder eingeprägt. Weiterhin wird ein zweiter Messstrom in einer zweiten Richtung durch einen zweiten Schaltkontakt der in der Reihenschaltung angeordneten Schaltkontakte eingespeist oder eingeprägt. Die erste Richtung und die zweite Richtung des ersten bzw. zweiten Messstroms sind bezogen auf die Reihenschaltung der Schaltkontakte entgegengesetzt gerichtet. Die Reihenschaltung ist beidseitig geerdet, d.h., der erste und zweite Messstrom werden eingespeist, während die Reihenschaltung beidseitig geerdet ist. Ein Widerstandswert des ersten Schaltkontakts wird in Abhängigkeit von dem ersten Messstrom bestimmt, während der erste und zweite Schaltkontakt geschlossen sind. Anders ausgedrückt werden der erste und der zweite Messstrom bei in Serie liegenden Schaltkontakten in jeweils entgegengesetzte Richtungen eingespeist. Bei beispielsweise zwei Schaltkontakten kann mit jeweils einer entsprechenden Stromquelle einmal von einem Punkt zwischen den Schaltkontakten an jeweils einen Punkt an beiden Enden des Leistungsschalters ein Strom eingespeist werden. Wenn der erste Messstrom und der zweite Messstrom jeweils beispielsweise 100 Ampere betragen, fließt somit ein Strom von 100 Ampere von dem Mittelpunkt zwischen den beiden Schaltkontakten in die eine Richtung durch den ersten Schaltkontakt und ein weiterer Strom von 100 Ampere von diesem Punkt in die entgegengesetzte Richtung durch den zweiten Schaltkontakt. Bei symmetrischen Bedingungen, d.h., wenn beide geschlossenen Schaltkontakte in etwa oder exakt den gleichen Widerstand aufweisen, tritt an beiden Schaltkontakten im Wesentlichen der gleiche Spannungsabfall auf, wobei der Spannungsabfall an dem geschlossenen ersten Schaltkontakt in entgegengesetzter Richtung zu dem Spannungsabfall über dem geschlossenen zweiten Schaltkontakt auftritt. Durch die Erdungen, welche an beiden Seiten des Leistungsschalters aus Sicherheitsgründen angeschlossen sind, fließt somit im Wesentlichen kein Strom, sodass auch im Wesentlichen keine Spannung an der Erdung abfällt. Somit beeinflusst die Erdung die Messung des Widerstandswerts des ersten Schaltkontakts im Wesentlichen nicht.

Gemäß einer Ausführungsform kann ferner ein Widerstandswert des zweiten Schaltkontakts in Abhängigkeit von dem zweiten Messstrom bestimmt werden, während der erste und zweite Schaltkontakt geschlossen sind. Da über der Erdungsschleife im Wesentlichen keine Spannung anliegt und somit durch die Erdung im Wesentlichen kein Strom fließt, kann auch der Widerstandswert des zweiten Schaltkontakts mit hoher Genauigkeit bestimmt werden.

Wenn der Leistungsschalter mehr als zwei in Reihe angeordnete Schaltkontakte aufweist, können die Schaltkontakte während des Bestimmens der Widerstandswerte des ersten und zweiten Schaltkontakts geschlossen sein. Da durch die Erdungsschleife im Wesentlichen kein Strom fließt, können beispielsweise bei einem Leistungsschalter mit vier Schaltkontakten, von denen jedoch nur aktuell zwei wie zuvor beschrieben gemessen werden, alle vier Schaltkontakte geschlossen werden, ohne die Messung negativ zu beeinflussen. Dabei kann der Leistungsschalter beidseitig geerdet sein. Somit kann der Leistungsschalter in seinen üblichen Betriebsarten geschaltet werden, d.h., es können entweder alle Schaltkontakte geöffnet oder alle Schaltkontakte geschlossen werden.

Gemäß einer weiteren Ausführungsform werden die Widerstandswerte des ersten und zweiten Schaltkontakts bestimmt, indem eine erste Spannung über dem ersten Schaltkontakt und eine zweite Spannung über dem zweiten Schaltkontakt gemessen wird. In Abhängigkeit von dem ersten Messstrom und der ersten Spannung kann dann der Widerstand des ersten Schaltkontakts bestimmt werden. Somit können übliche Widerstandsmessvorrichtungen zur Durchführung des Verfahrens verwendet werden.

Gemäß einer weiteren Ausführungsform werden der erste Messstrom und der zweite Messstrom derart eingestellt, dass ein Spannungsabfall über dem ersten Schaltkontakt gleich einem Spannungsabfall über dem zweiten Schaltkontakt ist. Dadurch kann die oben beschriebene Symmetrie hergestellt werden, d.h., es kann sichergestellt werden, dass über der Erdungsschleife kein Spannungsabfall auftritt und somit kein Strom durch die Erdungsschleife fließt. Dadurch können die Widerstände des ersten Schaltkontakts und des zweiten Schaltkontakts mit hoher Genauigkeit bestimmt werden.

Vorzugsweise sind der erste Schaltkontakt und der zweite Schaltkontakt benachbart in der Reihenschaltung der Schaltkontakte des Leistungsschalters angeordnet.

Gemäß einer weiteren Ausführungsform kann der Leistungsschalter mehrere Paare von Schaltkontakten aufweisen. Ein jeweiliges Paar von Schaltkontakten umfasst jeweils den zuvor definierten ersten und den zuvor definierten zweiten Schaltkontakt, welche jeweils benachbart zueinander angeordnet sind. Das zuvor beschriebene Verfahren zur Messung des Widerstands des jeweiligen ersten Schaltkontakts und zweiten Schaltkontakts wird gleichzeitig an mehreren Paaren von benachbarten ersten und zweiten Schaltkontakten des Leistungsschalters durchgeführt. Durch die unterschiedlichen Stromrichtungen in dem ersten und zweiten Schaltkontakt, insbesondere bei den zuvor beschriebenen symmetrischen Bedingungen ist, eine Gesamtspannung über einem Paar von Schaltkontakten jeweils null. Somit beeinflussen sich mehrere Paare von Schaltkontakten während einer gleichzeitigen Messung nicht. Darüber hinaus ist auch bei einer gleichzeitigen Messung an mehreren Paaren von benachbarten Schaltkontakten die Spannung über der Erdungsschleife null, sodass die Messung durch die Erdung des Leistungsschalters nicht beeinflusst wird. Durch die beidseitige Erdung des Leistungsschalters kann darüber hinaus eine Person, welche die Widerstandsmessung durchführt, vor unbeabsichtigt hohen Spannungen geschützt werden.

Wie zuvor beschrieben, kann der Leistungsschalter beispielsweise einen Höchst-, Hoch- oder Mittelspannungsschalter umfassen.

Gemäß der vorliegenden Erfindung wird auch eine Vorrichtung zur Messung von Widerständen von in einer Reihenschaltung angeordneten Schaltkontakten eines elektrischen Leistungsschalters bereitgestellt. Die Vorrichtung umfasst eine erste Einrichtung zum Einspeisen eines ersten Messstroms in einer ersten Richtung durch einen ersten Schaltkontakt der in der Reihenschaltung angeordneten Schaltkontakte. Die Vorrichtung umfasst weiterhin eine zweite Einrichtung zum Einspeisen eines zweiten Messstroms in einer zweiten Richtung durch einen zweiten Schaltkontakt der in der Reihenschaltung angeordneten Schaltkontakte. Die erste Richtung und die zweite Richtung sind bezogen auf die Reihenschaltung der Schaltkontakte entgegengesetzt gerichtet. Der erste und der zweite Messstrom werden eingespeist, während die Reihenschaltung beidseitig geerdet ist. Die Vorrichtung umfasst weiterhin eine Verarbeitungseinheit, welche mit der ersten Einrichtung und der zweiten Einrichtung sowie dem Leistungsschalter gekoppelt ist. Die Verarbeitungseinheit bestimmt in Abhängigkeit von dem ersten Messstrom einen ersten Widerstandswert des ersten Schaltkontakts, während der erste und der der zweite Schaltkontakt geschlossen sind. Die Verarbeitungseinheit kann beispielsweise einen Spannungsabfall über dem ersten Schaltkontakt bestimmen und in Abhängigkeit von dem ersten Messstrom und dem Spannungsabfall über dem ersten Schaltkontakt den Widerstandswert des geschlossenen ersten Schaltkontakts bestimmen. Da der erste Messstrom und der zweite Messstrom in entgegengesetzte Richtungen durch die Reihenschaltung der Schaltkontakte in dem Leistungsschalter fließen, fällt, sofern die Widerstände des ersten und zweiten Schaltkontakts im Wesentlichen gleich groß sind oder die Messströme geeignet gewählt werden, über dem ersten Schaltkontakt betragsmäßig die gleiche Spannung wie über dem zweiten Schaltkontakt ab. Die Spannungsrichtungen sind jedoch entgegengesetzt gerichtet, sodass über der Erdungsschleife, welche durch das beidseitige Erden der Reihenschaltung besteht, keine Spannung anliegt und somit kein Strom durch die Erdungsschleife fließt. Dadurch wird die Widerstandsmessung nicht durch die Erdungsschleife beeinflusst.

Die vorliegende Erfindung wird nachfolgend unter Bezugnahme auf die beigefügte Zeichnung anhand bevorzugter Ausführungsformen erläutert werden.
Fig. 1 zeigt eine Testumgebung mit einem beidseitig geerdeten elektrischen Leistungsschalter und einer Vorrichtung zur Messung eines Widerstands eines Schaltkontakts des Leistungsschalters, wobei das in Fig. 1 gezeigte Beispiel nicht Bestandteil der vorliegenden Erfindung ist.
Fig. 2-4 zeigen Testanordnungen mit Vorrichtungen zur Messung von Widerständen von Schaltkontakten von elektrischen Leistungsschaltern gemäß Ausführungsformen der vorliegenden Erfindung.

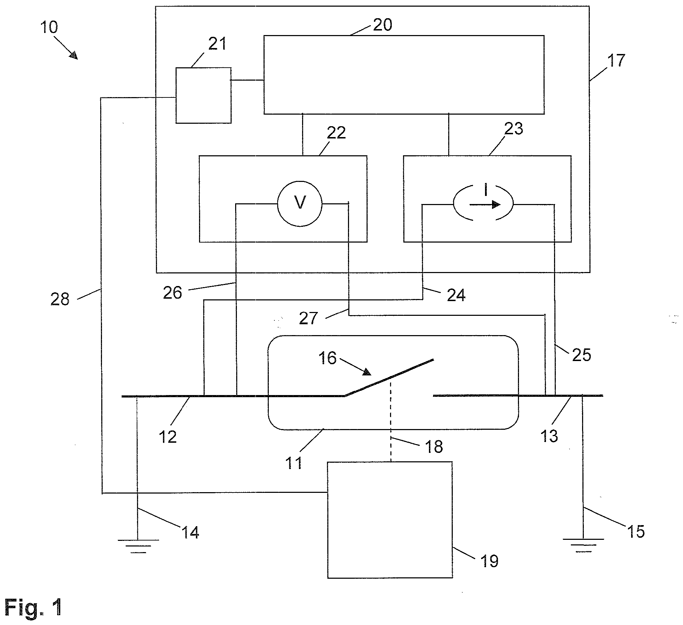

Fig. 1 zeigt eine Testumgebung 10 mit einem Leistungsschalter 11, welcher eine erste Hochspannungsleitung 12 wahlweise mit einer zweiten Hochspannungsleitung 13 verbindet oder davon trennt. Die Testumgebung 10 umfasst weiterhin eine erste Erdungsgarnitur 14, welche mit einer ersten Seite des Leistungsschalters 11 gekoppelt ist, und eine zweite Erdungsgarnitur 15, welche mit einer zweiten Seite des Leistungsschalters 11 gekoppelt ist. Durch das beidseitige Erden des Leistungsschalters kann sichergestellt werden, dass keine gefährlich hohen Spannungen an dem Leistungsschalter 11 anliegen. Die Testumgebung 10 umfasst weiterhin eine Mikroohmmessvorrichtung 17, welche über vier Verbindungen 24-27 mit den beiden Seiten des Leistungsschalters 11 gekoppelt ist. Der Leistungsschalter 11 umfasst einen elektrischen Schaltkontakt 16, welcher mittels eines Steuerantriebs 19 und einer mechanischen Kopplung 18 wahlweise geöffnet oder geschlossen werden kann, um eine Verbindung zwischen den Leitungen 12 und 13 herzustellen oder zu unterbrechen. Der Steuerantrieb 19 kann beispielsweise über eine Steuerleitung 28 angesteuert werden, um den Schaltkontakt 16 zu öffnen oder zu schließen. Darüber hinaus kann der Steuerantrieb 19 von einer Bedienperson manuell angesteuert oder betätigt werden, um den Schaltkontakt 16 wahlweise zu öffnen oder zu schließen.

Die Vorrichtung 17 umfasst eine Widerstandsmesseinrichtung, welche beispielsweise eine Stromquelle 23 und einen Spannungsmesser 22 umfasst. Die Stromquelle 23 prägt über die Verbindungen 24, 25 einen Strom I durch den Leistungsschalter 11 und die beidseitige Erdung 14, 15 ein und der Spannungsmesser 22 erfasst über die Verbindungen 26, 27 einen Spannungsabfall V über dem Leistungsschalter 11. Die Vorrichtung 17 umfasst weiterhin eine Verarbeitungseinheit 20, welche in Abhängigkeit von dem von der Stromquelle 23 eingeprägten Strom I und der von dem Spannungsmesser 22 gemessenen Spannung V einen Widerstand über dem Leistungsschalter 11 berechnet. Die Verarbeitungseinheit 20 ist ferner mit einer Ansteuereinheit 21 der Vorrichtung 17 gekoppelt, welche über die Verbindung 28 den Steuerantrieb 19 des Leistungsschalters 11 ansteuert. Somit ist die Verarbeitungseinheit 20 in der Lage, den Schaltkontakt 16 wahlweise zu öffnen oder zu schließen. Die Arbeitsweise der Vorrichtung 17 wird nachfolgend beschrieben werden.

Der Leistungsschalter 11 wird mithilfe der Erdungsgarnituren 14 und 15 beidseitig geerdet. Die Widerstandsmesseinrichtung 22, 23 wird, wie in Fig. 1 dargestellt, derart an den Leistungsschalter 11 angeschlossen, dass ein Widerstand über dem Leistungsschalter 11 messbar ist. Dann werden zwei Widerstandswerte nacheinander ermittelt. Ein Widerstandswert R₁ wird bei geschlossenem Schaltkontakt 16 ermittelt und ein Widerstandswert R₂ wird bei geöffnetem Schaltkontakt 16 ermittelt. Der Widerstand R₁ entspricht somit einer Parallelschaltung aus dem Widerstand des Schaltkontakts 16 und der Erdungsschleife über die Erdungsgarnituren 14, 15, und der Widerstand R₂ entspricht nur dem Widerstand der Erdungsschleife über die Erdungsgarnituren 14, 15. Mithilfe der weiter oben beschriebenen Gleichung kann aus diesen beiden Widerstandswerten der Widerstand des geschlossenen Schaltkontakts 16 berechnet werden. Dies wird von der Verarbeitungseinheit 20 durchgeführt. Die Verarbeitungseinheit 20 kann ferner über die Steuereinheit 21 den Schaltkontakt 16 wahlweise öffnen oder schließen und daher die beiden Widerstandsmessungen der Reihe nach einmal bei geöffnetem und einmal bei geschlossenem Schaltkontakt 16 durchführen und anschließend den Widerstand des geschlossenen Schaltkontakts 16 daraus berechnen. Eine Reihenfolge, in welcher die beiden Widerstandsmessungen durchgeführt werden, ist beliebig. Alternativ kann die Verarbeitungseinheit 20 über eine entsprechende Anzeige einen Benutzer anweisen, den Schaltkontakt 16 manuell oder über eine entsprechende Betätigungsvorrichtung zu öffnen oder zu schließen, wenn eine automatische Ansteuerung über die Ansteuereinheit 21 und die Verbindung 28 nicht vorgesehen ist. Da während der gesamten Messung der Leistungsschalter 11 beidseitig geerdet ist, kann sichergestellt werden, dass keine gefährlich hohen Spannungen an dem Leistungsschalter 11 anliegen.

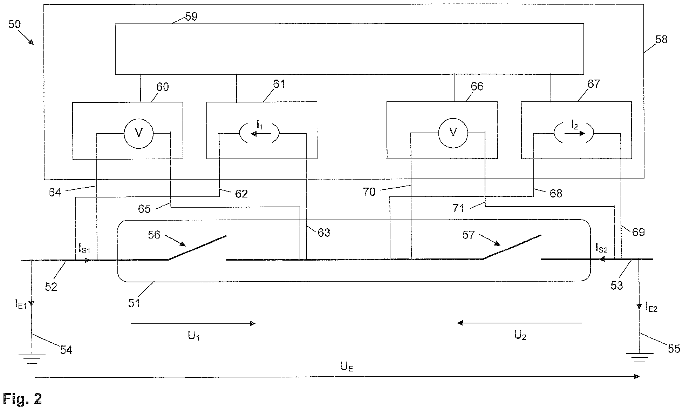

Fig. 2 zeigt eine weitere Testumgebung 50 mit einem Leistungsschalter 51, welcher zwei Schaltkontakte 56 und 57 umfasst. Die Schaltkontakte 56 und 57 sind in einer Reihenschaltung angeordnet. Der Leistungsschalter 51 kann weitere Schaltkontakte umfassen, welche zusammen mit den Schaltkontakten 56 und 57 in einer Reihenschaltung angeordnet sind. Die Schaltkontakte 56 und 57 und die gegebenenfalls vorhandenen weiteren Schaltkontakte werden im Allgemeinen gleichzeitig mittels eines nicht gezeigten Stellantriebs wahlweise geöffnet oder geschlossen. Der Leistungsschalter 51 ist mit Hochspannungsleitungen 52 und 53 gekoppelt, welche über die Schaltkontakte 56, 57 wahlweise verbunden oder getrennt werden können. Die Testumgebung 50 umfasst ferner zwei Erdungsgarnituren 54 und 55, welche die Hochspannungsleitungen 52 bzw. 53 mit Erde verbinden. Weiterhin ist in der Testumgebung 50 eine Vorrichtung 58 zur Messung des Widerstandes der Schaltkontakte 56 und 57 gezeigt. Die Vorrichtung 58 umfasst eine erste Widerstandsmesseinheit, welche einen Spannungsmesser 60 und eine Stromquelle 61 umfasst, sowie eine zweite Widerstandsmesseinheit, welche einen Spannungsmesser 66 und eine Stromquelle 67 umfasst. Die erste Widerstandsmesseinrichtung 60, 61 ist über Verbindungen 62-65 mit dem ersten Schaltkontakt 56 derart verbunden, dass ein Strom I₁ der Stromquelle 61 über den Schaltkontakt 65 eingeprägt werden kann, wenn der Schaltkontakt 56 geschlossen ist. Der Spannungsmesser ist über die Verbindungen 64 und 65 derart mit dem Schaltkontakt 56 verbunden, dass ein Spannungsabfall U₁ über dem Schaltkontakt 56 gemessen werden kann. Die zweite Widerstandsmesseinrichtung 66, 67 ist vergleichbar zu der ersten Widerstandsmesseinrichtung 60, 61 mit dem Schaltkontakt 57 über Verbindungen 68-71 zum Einprägen eines Stroms I₂ durch den geschlossenen Schaltkontakt 57 und Messen eines Spannungsabfalls U₂ über dem Schaltkontakt 57 gekoppelt. Eine Verarbeitungseinheit 59 ist mit den Widerstandsmesseinrichtungen 60, 61 bzw. 66, 67 verbunden. Die Arbeitsweise der Vorrichtung 58 wird nachfolgend beschrieben werden.

Die Hochspannungsleitungen 52, 53, welche an beiden Enden des Leistungsschalters 51 angeschlossen sind, werden über die Erdungsgarnituren 54, 55 mit Erde verbunden. Die Vorrichtung 58 wird wie zuvor beschrieben an die Schaltkontakte 56 und 57 angeschlossen. Die Schaltkontakte 56 und 57 werden geschlossen. Von der Stromquelle 61 wird ein Strom I₁ auf die Hochspannungsleitung 52 eingeprägt. Der Strom I₁ fließt daher zum Teil als Strom I_{S1} von links nach rechts durch den geschlossenen Schaltkontakt 56 und zu einem anderen Teil als Strom I_{E1} über die Erdungsgarnitur 54 nach Erde ab. Die Stromquelle 67 prägt einen Strom I₂ auf die Hochspannungsleitung 53 ein. Der Strom I₂ fließt zum Teil als Strom I_{S2} von rechts nach links durch den geschlossenen Schaltkontakt 57 und zu einem weiteren Teil als Strom I_{E2} durch die Erdungsgarnitur 55 nach Erde ab. Aufgrund des Übergangswiderstands des Schaltkontakts 56 tritt über dem Schaltkontakt 56 ein Spannungsabfall U₁ auf. Ebenso tritt aufgrund des Übergangswiderstands des Schaltkontakts 57 ein Spannungsabfall U₂ über dem Schaltkontakt 57 auf. Da die Ströme I_{S1} und I_{S2} entgegengesetzt gerichtet eingespeist werden, sind die Spannungsabfälle U₁ und U₂ ebenfalls entgegengesetzt gerichtet. Wenn die Übergangswiderstände der Schaltkontakte 56 und 57 im Wesentlichen gleich sind und darüber hinaus die Ströme I₁ und I₂ im Wesentlichen gleich sind, sind die Spannungsabfälle U₁ und U₂ ebenfalls betragsmäßig gleich. Dadurch ist der Spannungsabfall U_{E} über der Erdungsschleife gleich null, sodass auch die Ströme I_{E1} und I_{E2} jeweils null sind. In diesem Fall entspricht der Strom I_{S1} durch den Schaltkontakt 56 dem Strom I₁, sodass der Übergangswiderstand des Schaltkontakts 56 einzig in Abhängigkeit von dem Strom I₁ und der von dem Spannungsmesser 60 gemessenen Spannung U₁ bestimmt werden kann. Ebenso kann der Übergangswiderstand des geschlossenen Schaltkontakts 57 einzig anhand des Stroms I₂, welcher in diesem Fall dem Strom I_{S2} entspricht, und der von dem Spannungsmesser 66 gemessenen Spannung U₂ bestimmt werden. Da die Schaltkontakte 56 und 57 im Allgemeinen baugleich sind und einer gleichen Beanspruchung unterliegen, weisen sie im Allgemeinen einen gleichen Übergangswiderstand im geschlossenen Zustand auf, sodass die zuvor beschriebenen Bedingungen erfüllt werden und für diesen sogenannten symmetrischen Fall eine einfache und genaue Bestimmung der Übergangswiderstände möglich ist. Die Verarbeitungseinheit 59 kann die entsprechenden Widerstandswerte anhand von Informationen der Widerstandsmesseinrichtungen 60, 61 und 66, 67 bestimmen und ausgeben. Für den Fall, dass die Übergangswiderstände der Schaltkontakte 56 und 57 unterschiedlich groß sind, kann die Steuervorrichtung 59 die Ströme I₁ und I₂ derart einstellen, dass die Spannungsabfälle U₁ und U₂ betragsmäßig im Wesentlichen gleich sind. Dadurch wird erreicht, dass auch in diesem nicht symmetrischen Fall die Spannung U_{E} über der Erdungsschleife im Wesentlichen null beträgt und somit der Übergangswiderstand der einzelnen Schaltkontakte 56 und 57 anhand des Stroms I₁ bzw. I₂ und der Spannungsabfälle U₁ bzw. U₂ bestimmt werden können.

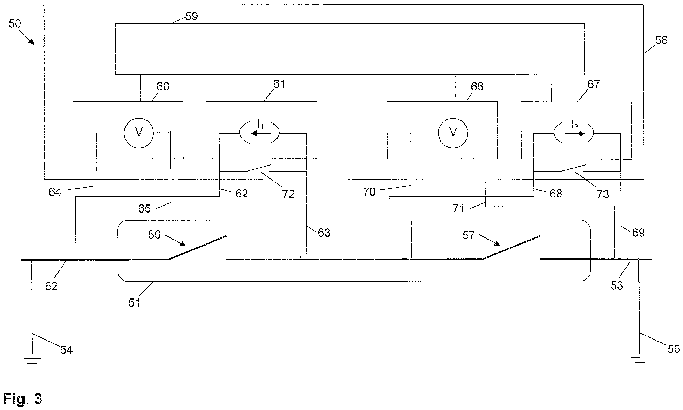

Fig. 3 zeigt eine weitere Testumgebung 50, welche im Wesentlichen der Testumgebung 50 der Fig. 2 entspricht und darüber hinaus zwei zusätzliche Schalter 72 und 73 umfasst, welche parallel zu den Schaltkontakten 56 bzw. 57 angeordnet sind. Dadurch wird ermöglicht, dass auch bei geöffneten Schaltkontakten 56 bzw. 57 ein Strom durch die Erdungsschleife, welche über die Erdungsgarnituren 54 und 55 realisiert wird, getrieben werden kann, um den Widerstand der Erdschleife ermitteln zu können. Der Widerstand der Erdschleife kann dann zur Korrektur von Widerstandswerten verwendet werden, welche bei geschlossenen Schaltkontakten 56, 57 ermittelt werden. Anders ausgedrückt kann mithilfe der Schalter 72, 73 auch bei der in Fig. 3 gezeigten Anordnung das im Zusammenhang mit Fig. 1 beschriebene Verfahren durchgeführt werden. Beispielsweise kann der Schalter 73 geschlossen und der Schalter 72 geöffnet werden. Eine Mikroohmmessung des Schaltkontakts 56 kann dann mithilfe der Widerstandsmesseinrichtung 60, 61 wie zuvor unter Bezugnahme auf Fig. 1 beschrieben durchgeführt werden. Bei geschlossenem Schalter 72 und geöffnetem Schalter 73 kann mithilfe der Widerstandsmesseinrichtung 66, 67 eine Mikroohmmessung an dem Schaltkontakt 57 wie zuvor unter Bezugnahme auf Fig. 1 beschrieben durchgeführt werden.

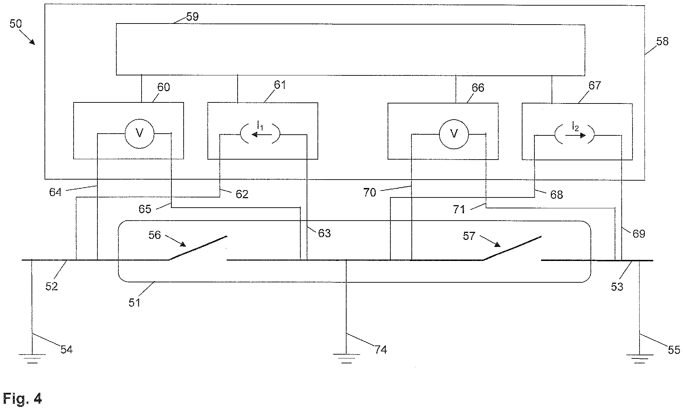

Fig. 4 zeigt eine Testumgebung 50, welche im Wesentlichen der Testumgebung 50 der Fig. 2 entspricht. Zusätzlich umfasst die Testumgebung 50 der Fig. 4 eine dritte Erdungsgarnitur 74, welche einen Punkt zwischen dem Schaltkontakt 56 und dem Schaltkontakt 57 mit Erde koppelt. Bei dieser Anordnung kann mithilfe der Widerstandsmesseinrichtung 60, 61 eine Mikroohmmessung des Schaltkontakts 56 wie unter Bezugnahme auf Fig. 1 zuvor beschrieben wurde durchgeführt werden. Ebenso kann mithilfe der Widerstandsmesseinrichtung 66, 67 eine Mikroohmmessung des Schaltkontakts 57 wie zuvor unter Bezugnahme auf Fig. 1 beschrieben durchgeführt werden. Die beiden Mikroohmmessungen an den Schaltkontakten 56 und 57 können gleichzeitig durchgeführt werden. Durch diese zusätzliche Erdung 74 kann ferner sichergestellt werden, dass auch zwischen den Schaltkontakten 56 und 57 keine Hochspannung anliegt.

## Patentansprüche

1. Verfahren zur Messung von Widerständen von in einer Reihenschaltung angeordneten Schaltkontakten eines elektrischen Leistungsschalters, umfassend:
- Einspeisen eines ersten Messstroms (I_{S1}) in einer ersten Richtung durch einen ersten Schaltkontakt (56) der in der Reihenschaltung angeordneten Schaltkontakte,
- Einspeisen eines zweiten Messstroms (I_{S2}) in einer zweiten Richtung durch einen zweiten Schaltkontakt (57) der in der Reihenschaltung angeordneten Schaltkontakte, wobei die erste Richtung und die zweite Richtung bezogen auf die Reihenschaltung der Schaltkontakte entgegengesetzt gerichtet sind, wobei der erste und zweite Messstrom gleichzeitig eingespeist werden, während die Reihenschaltung beidseitig geerdet ist, und
- Bestimmen eines Widerstandswerts des ersten Schaltkontakts (56) in Abhängigkeit von dem ersten Messstrom (I_{S1}), während der erste und zweite Schaltkontakt geschlossen sind.

2. Verfahren nach Anspruch 1, ferner umfassend:
- Bestimmen eines Widerstandswerts des zweiten Schaltkontakts (57) in Abhängigkeit von dem zweiten Messstrom (I_{S2}), während der erste und zweite Schaltkontakt geschlossen sind.

3. Verfahren nach Anspruch 2, wobei die Schaltkontakte (56, 57) des Leistungsschalters (51) während des Bestimmens der Widerstandswerte des ersten und zweiten Schaltkontakts (56, 57) geschlossen sind.

4. Verfahren nach Anspruch 2 oder 3, wobei das Bestimmen der Widerstandswerte des ersten und zweiten Schaltkontakts (56, 57) umfasst:
- Messen einer ersten Spannung (U₁) über dem ersten Schaltkontakt (56), und
- Messen einer zweiten Spannung (U₂) über dem zweiten Schaltkontakt (57).

5. Verfahren nach einem der Ansprüche 1-4, wobei der erste und zweite Messstrom (I_{S1}, I_{S2}) eingespeist werden, während der elektrische Leistungsschalter (51) beidseitig geerdet ist.

6. Verfahren nach einem der Ansprüche 1-5, wobei der erste Messstrom (I_{S1}) und der zweite Messstrom (I_{S2}) derart eingestellt werden, dass ein Spannungsabfall (U₁) über dem ersten Schaltkontakt (56) gleich einem Spannungsabfall (U₂) über dem zweiten Schaltkontakt (57) ist.

7. Verfahren nach einem der Ansprüche 1-6, wobei in der Reihenschaltung der erste Schaltkontakt (56) benachbart zu dem zweiten Schaltkontakt (57) angeordnet ist.

8. Verfahren nach einem der Ansprüche 1-7, wobei der Leistungsschalter (51) mehrere Paare von Schaltkontakten umfasst, wobei ein Paar von Schaltkontakten jeweils einen ersten und einen benachbarten zweiten Schaltkontakt umfasst, wobei das Verfahren gleichzeitig an mehreren Paaren von benachbarten Schaltkontakten des Leistungsschalters durchgeführt wird.

9. Verfahren nach einem der Ansprüche 1-8, wobei der Leistungsschalter (51) einen Höchst-, Hoch- oder Mittelspannungsschalter umfasst.

10. Vorrichtung zur Messung von Widerständen von in einer Reihenschaltung angeordneten Schaltkontakten eines elektrischen Leistungsschalters, umfassend:
- eine erste Einrichtung (61) zum Einspeisen eines ersten Messstroms (I_{S1}) in einer ersten Richtung durch einen ersten Schaltkontakt (56) der in der Reihenschaltung angeordneten Schaltkontakte,
- eine zweite Einrichtung (67) zum Einspeisen eines zweiten Messstroms (I_{S2}) in einer zweiten Richtung durch einen zweiten Schaltkontakt (57) der in der Reihenschaltung angeordneten Schaltkontakte, wobei die erste Richtung und die zweite Richtung bezogen auf die Reihenschaltung der Schaltkontakte entgegengesetzt gerichtet sind, wobei der erste und zweite Messstrom gleichzeitig eingespeist werden, während die Reihenschaltung beidseitig geerdet ist, und
- eine Verarbeitungseinheit (59), welche mit der ersten und zweiten Einrichtung (60, 67) gekoppelt ist und ausgestaltet ist, einen ersten Widerstandswert des ersten Schaltkontakts (56) in Abhängigkeit von dem ersten Messstrom (I_{S1}) zu bestimmen, während der erste und zweite Schaltkontakt (56, 57) geschlossen sind.

11. Vorrichtung nach Anspruch 10, wobei zu dem ersten Schaltkontakt (56) und zu dem zweiten Schaltkontakt (57) jeweils ein Schalter (72, 73) parallel geschaltet ist.

12. Vorrichtung nach Anspruch 10 oder 11, wobei eine erste Erdungsgarnitur (54) mit dem ersten Schaltkontakt (56) und eine zweite Erdungsgarnitur (55) mit dem zweiten Schaltkontakt (57) verbunden ist.

13. Vorrichtung nach Anspruch 12, wobei eine dritte Erdungsgarnitur (74) mit einem Punkt zwischen dem ersten Schaltkontakt (56) und dem zweiten Schaltkontakt (57) verbunden ist.

14. Vorrichtung nach einem der Ansprüche 10-13, wobei die Vorrichtung (58) zur Durchführung des Verfahrens nach einem der Ansprüche 1-9 ausgestaltet ist.

## Claims

1. A method for the measurement of resistances of switching contacts arranged in a series connection of an electrical circuit breaker, comprising:
- feeding a first measurement current (I_{S1}) in a first direction through a first switching contact (56) of the switching contacts arranged in the series connection;
- feeding a second measurement current (I_{S2}) in a second direction through a second switching contact (57) of the switching contacts arranged in the series connection, the first direction and the second direction being opposite to one another with respect to the series connection of the switching contacts, and the first measurement current and the second measurement current being fed while the series connection is grounded at both sides; and
- determining a resistance value of the first switching contact (56) on the basis of the first measurement current (I_{S1}) while the first switching contact and the second switching contact are closed.

2. The method according to claim 1, further comprising:
- determining a resistance value of the second switching contact (57) based on the second measurement current (I_{S2}) while the first switching contact and the second switching contact are closed.

3. The method according to claim 2, wherein the switching contacts (56, 57) of the circuit breaker (51) are closed while the determining of the resistance values of the first and second switching contacts (56, 57).

4. The method according to claim 2 or claim 3, wherein the determining of the resistance values of the first and second switching contacts (56, 57) comprises:
- measuring a first voltage (U₁) across the first switching contact (56); and
- measuring a second voltage (U₂) across the second switching contact (57).

5. The method according to any one of claims 1-4, wherein the first and second measurement currents (I_{S1}, I_{S2}) are fed while the circuit breaker (51) is grounded at both sides.

6. The method according to any one of claims 1-5, wherein the first measurement current (I_{S1}) and the second measurement current (I_{S2}) are adjusted such that a voltage drop (U₁) across the first switching contact (56) equals a voltage drop (U₂) across the second switching contact (57).

7. The method according to any one of claims 1-6, wherein in the series connection the first switching contact (56) is arranged adjacent to the second switching contact (57).

8. The method according to any one of claims 1-7, wherein the circuit breaker (51) comprises a plurality of pairs of switching contacts, each of the pairs of switching contacts comprising a first switching contact and an adjacent second switching contact, and wherein the method is simultaneously carried out on several of the pairs of adjacent switching contacts of the circuit breaker.

9. The method according to any one of claims 1-8, wherein the circuit breaker (51) comprises one of an ultra-high voltage switch, a high voltage switch, and a medium voltage switch.

10. An apparatus for the measurement of resistances of switching contacts arranged in a series connection of an electrical circuit breaker, comprising:
- a first device (61) for feeding a first measurement current (I_{S1}) in a first direction through a first switching contact (56) of the switching contacts arranged in the series connection;
- a second device (67) for feeding a second measurement current (I_{S2}) in a second direction through a second switching contact (57) of the switching contacts arranged in the series connection, the first direction and the second direction being opposite to one another with respect to the series connection of the switching contacts, and the first measurement current and the second measurement current being fed while the series connection is grounded at both sides; and
- a processing unit (59) which is coupled to the first device (60) and the second device (67) and which is configured to determine a resistance value of the first switching contact (56) on the basis of the first measurement current (I_{S1}) while the first switching contact and the second switching contact are closed.

11. The apparatus according to claim 10, wherein a switch (72,73) is connected in parallel with each of the first switching contact (56) and the second switching contact (57).

12. The apparatus according to claim 10 or claim 11, wherein a first grounding device (54) is connected with the first switching contact (56) and a second grounding device (55) is connected with the second switching contact (57).

13. The apparatus according to claim 12, wherein a third grounding device (74) is connected with a point between the first switching contact (56) and the second switching contact (57).

14. The apparatus according to any one of claims 10-13, wherein the apparatus (58) is configured to carry out the method according to any one of claims 1-9.

## Revendications

1. Procédé de mesure de résistances de contacts de commutation, agencés dans un circuit en série, d'un disjoncteur de puissance électrique, comprenant :
- l'introduction d'un premier courant de mesure (I_{S1}) dans un premier sens à travers un premier contact de commutation (56) des contacts de commutation agencés dans le circuit en série,
- l'introduction d'un deuxième courant de mesure (I_{S2}) dans un deuxième sens à travers un deuxième contact de commutation (57) des contacts de commutation agencés dans le circuit en série, dans lequel le premier sens et le deuxième sens sont dirigés à l'opposé l'un de l'autre par rapport au circuit en série des contacts de commutation, dans lequel le premier et le deuxième courant de mesure sont introduits en même temps pendant que le circuit en série est mis à la terre des deux côtés, et
- la détermination d'une valeur de résistance du premier contact de commutation (56) en fonction du premier courant de mesure (I_{S1}) pendant que le premier et le deuxième contact de commutation sont fermés.

2. Procédé selon la revendication 1, comprenant en outre :
- la détermination d'une valeur de résistance du deuxième contact de commutation (57) en fonction du deuxième courant de mesure (I_{S2}) pendant que le premier et le deuxième contact de commutation sont fermés.

3. Procédé selon la revendication 2, dans lequel les contacts de commutation (56, 57) du disjoncteur de puissance (51) sont fermés pendant la détermination des valeurs de résistance du premier et du deuxième contact de commutation (56, 57).

4. Procédé selon la revendication 2 ou 3, dans lequel la détermination des valeurs de résistance du premier et du deuxième contact de commutation (56, 57) comprend :
- la mesure d'une première tension (U₁) sur le premier contact de commutation (56), et
- la mesure d'une deuxième tension (U₂) sur le deuxième contact de commutation (57).

5. Procédé selon l'une quelconque des revendications 1 à 4, dans lequel le premier et le deuxième courant de mesure (I_{S1}, I_{S2}) sont introduits pendant que le disjoncteur de puissance électrique (51) est mis à la terre des deux côtés.

6. Procédé selon l'une quelconque des revendications 1 à 5, dans lequel le premier courant de mesure (I_{S1}) et le deuxième courant de mesure (I_{S2}) sont réglés de telle sorte qu'une chute de tension (U₁) au premier contact de commutation (56) est égale à une chute de tension (U₂) au deuxième contact de commutation (57).

7. Procédé selon l'une quelconque des revendications 1 à 6, dans lequel, dans le circuit en série, le premier contact de commutation (56) est agencé au voisinage du deuxième contact de commutation (57).

8. Procédé selon l'une quelconque des revendications 1 à 7, dans lequel le disjoncteur de puissance (51) comprend plusieurs paires de contacts de commutation, dans lequel une paire de contacts de commutation comprend à chaque fois un premier et un deuxième contact de commutation voisin, dans lequel le procédé est mis en oeuvre simultanément au niveau de plusieurs paires de contacts de commutation voisins du disjoncteur de puissance.

9. Procédé selon l'une quelconque des revendications 1 à 8, dans lequel le disjoncteur de puissance (51) comprend un disjoncteur de très haute tension, de haute tension ou de moyenne tension.

10. Dispositif de mesure de résistances de contacts de commutation, agencés dans un circuit en série, d'un disjoncteur de puissance électrique, comprenant :
- un premier dispositif (61) pour l'introduction d'un premier courant de mesure (I_{S1}) dans un premier sens à travers un premier contact de commutation (56) des contacts de commutation agencés dans le circuit en série,
- un deuxième dispositif (67) pour l'introduction d'un deuxième courant de mesure (I_{S2}) dans un deuxième sens à travers un deuxième contact de commutation (57) des contacts de commutation agencés dans le circuit en série, dans lequel le premier sens et le deuxième sens sont dirigés à l'opposé l'un de l'autre par rapport au circuit en série des contacts de commutation, dans lequel le premier et le deuxième courant de mesure sont introduits en même temps pendant que le circuit en série est mis à la terre des deux côtés, et
- une unité de traitement (59) qui est couplée au premier et au deuxième dispositif (60, 67) et qui est réalisée pour déterminer une première valeur de résistance du premier contact de commutation (56) en fonction du premier courant de mesure (I_{S1}) pendant que le premier et le deuxième contact de commutation (56, 57) sont fermés.

11. Dispositif selon la revendication 10, dans lequel un commutateur (72, 73) est branché à chaque fois en parallèle du premier contact de commutation (56) et du deuxième contact de commutation (57).

12. Dispositif selon la revendication 10 ou 11, dans lequel un premier équipement de mise à la terre (54) est relié au premier contact de commutation (56) et un deuxième équipement de mise à la terre (55) est relié au deuxième contact de commutation (57).

13. Dispositif selon la revendication 12, dans lequel un troisième équipement de mise à la terre (74) est relié à un point entre le premier contact de commutation (56) et le deuxième contact de commutation (57).

14. Dispositif selon l'une quelconque des revendications 10 à 13, dans lequel le dispositif (58) est réalisé pour la mise en oeuvre du procédé selon l'une quelconque des revendications 1 à 9.
